# FASCICULE DE BREVET EUROPEEN

(11) **EP 3 819 951 B1**
(45) Date de publication et mention de la délivrance du brevet: **28.09.2022**
(21) Numéro de dépôt: 20205849.1
(22) Date de dépôt: 05.11.2020
(51) Int. Cl.: H01L 41/04

(54) **DISPOSITIF ÉLECTROMÉCANIQUE À BASE DE POLYMÈRES FERROÉLECTRIQUES ET PROCÉDÉS DE FABRICATION D'UN TEL DISPOSITIF**
ELEKTROMECHANISCHE VORRICHTUNG AUF DER BASIS FERROELEKTRISCHER POLYMERE, UND VERFAHREN ZUR HERSTELLUNG EINER SOLCHEN VORRICHTUNG
ELECTROMECHANICAL DEVICE MADE OF FERROELECTRIC POLYMERS AND METHODS FOR MANUFACTURING SUCH A DEVICE

(30) Priorité: 07.11.2019 FR 1912493
(43) Date de publication de la demande: 12.05.2021
(73) Titulaire: Commissariat à l'énergie atomique et aux énergies alternatives, 75015 Paris (FR)
(72) Inventeur: BENWADIH, Mohammed, 38054 GRENOBLE CEDEX 09 (FR)
(74) Mandataire: Brevalex

(56) Documents cités:
- EP-A2- 2 323 188
- EP-A2- 2 323 188
- EP-A2- 2 463 926
- EP-A2- 2 463 926
- US-A1- 2008 007 140
- US-A1- 2008 007 140
- US-A1- 2012 200 200
- US-A1- 2012 200 200

## Description

### Domaine technique

L'invention concerne le domaine des dispositifs électromécaniques à base de matériau organique.

L'invention a ainsi plus précisément pour objet un dispositif électromécanique à base de polymères ferroélectriques et un procédé de fabrication d'un tel dispositif électromagnétique.

### État de l'art antérieur

Afin de fournir des dispositifs électromécaniques, tel que des actionneurs ou encore des capteurs pression, il est connu d'utiliser des dispositifs électromécaniques à base de polymères ferroélectriques. De tels dispositifs électromécaniques sont notamment particulièrement avantageux pour équiper des circuits imprimés flexibles.

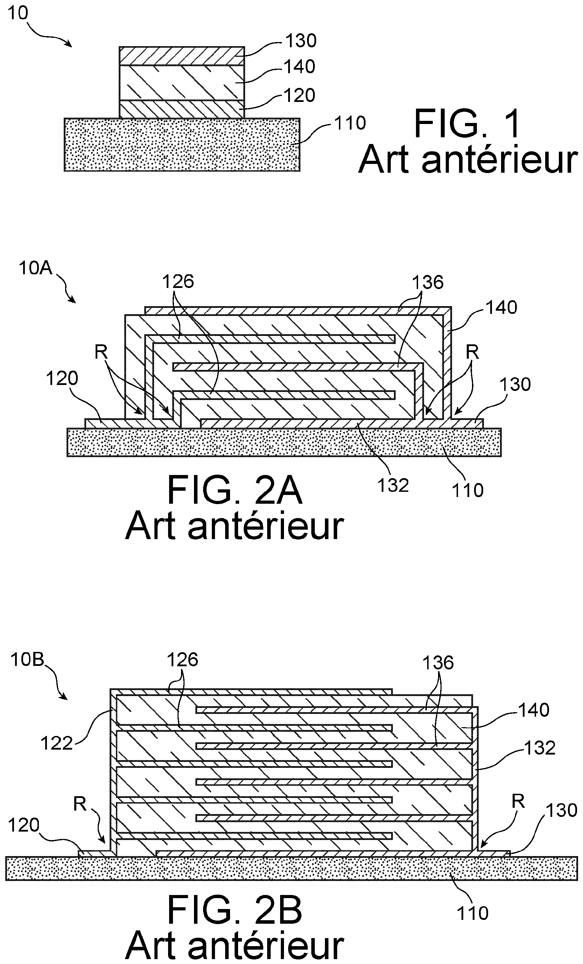

Un tel dispositif électromécanique 10 comporte généralement, comme illustré sur la figure 1 :
- une première électrode 120 métallique disposée sur un support 110, tel qu'un support en verre ou en polyamide,
- une couche active 140 comprenant un polymère ferroélectrique, tel qu'un poly(fluorure de vinylidène) ou un copolymère poly(fluorure de vinylidène-co-trifluoroéthylène),
- une deuxième électrode 130 métallique.

La couche active 140 est agencée en contact électrique entre la première et la deuxième électrode 120, 130 ceci d'une telle manière à permettre, à partir desdites première et deuxième électrodes 120, 130, de lui appliquer une différence de potentiel, dans le cas d'une application d'actionneur, ou à permettre de mesurer un champ électrique qui y règne, dans le cas d'une application de capteur.

On notera que généralement, dans un tel dispositif électromécanique, afin de permettre une déformation de la couche active sans rupture de la connexion des électrodes, au moins l'une de la première et de la deuxième électrode comporte au moins l'un parmi des particules métalliques et des fils métalliques.

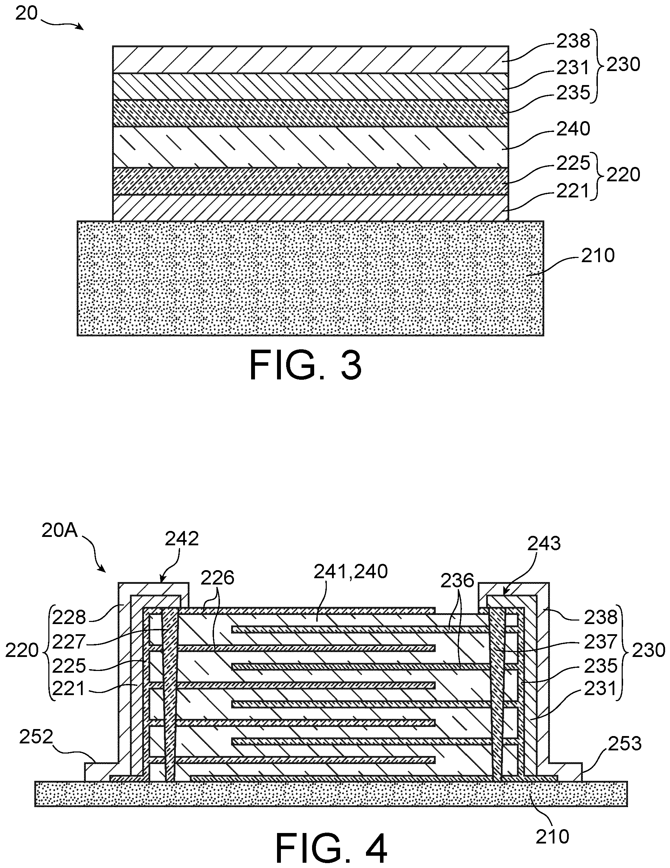

Les figures 2 et 3 illustrent des exemples d'application pratiques pour de tels dispositifs électromécaniques qui permettent d'en optimiser les performances par une configuration « multi-étages » de la couche active. Ces deux exemples sont basés sur une couche active 140 comportant une pluralité de portions s'étendant chacune le long d'un plan du dispositif électromécanique 10A 10B parallèlement les unes aux autres, les portions se succédant le long d'une direction perpendiculaire au plan du dispositif. Deux portions successives de la couche active 140 sont au moins partiellement séparées l'une de l'autre par une couche d'électrode intermédiaire 126, 136 métallique appartenant à l'une de la première et la deuxième électrode 120, 130 de telle manière que pour deux couches d'électrode intermédiaire successives 126, 136, une couche d'électrode intermédiaire 126 est comprise dans la première électrode 120 et l'autre couche d'électrode intermédiaire 136 est comprise dans la deuxième électrode 230.

Pour le dispositif électromécanique 10A selon le premier exemple d'application pratique, la première et la deuxième électrode 120, 130 comporte une portion de contact 121, 122 s'étendant partiellement sous la couche active 140 à partir de laquelle s'étend les couches d'électrode intermédiaire 126, 136 avec les couches d'électrode intermédiaire les plus externes qui entoure les couches d'électrode intermédiaire les plus internes.

Pour le dispositif électromécanique 10B selon le deuxième exemple d'application pratique, la première et la deuxième électrode 120, 130 comporte une portion latérale 122, 132 s'étendant perpendiculairement au plan de la couche électromécanique ceci pour connecter chacune des couches d'électrode intermédiaire 126, 136 correspondant à ladite électrode 120, 130.

Si de tels dispositifs électromécaniques 10, 10A, 10B permettent d'obtenir des performances électromécaniques particulièrement intéressantes ceci tout en assurant une adaptation aux circuits imprimés flexibles, ils présentent néanmoins un inconvénient majeur.

En effet, de tels dispositifs électromécaniques sont amenés, de par leur fonction, à être soumis à des déformations importantes qui entrainent généralement une détérioration des première et deuxième électrodes. Cette détérioration génère des ruptures de connexions des électrodes aux emplacements indiqués sous la référence R dans les figures 2 et 3 et le disfonctionnement de ces dispositifs. De ce fait, de tels dispositifs électromécaniques ne présentent pas une fiabilité optimale. Des dispositifs électromécaniques sont également divulgués dans US 2012/200200 A1, EP2463926 A2 et EP2323188 A2.

### Exposé de l'invention

L'invention vise à résoudre l'inconvénient ci-dessus et a ainsi pour but de fournir un dispositif électromécanique qui soit plus fiable vis-à-vis des dispositifs de l'art antérieur

L'invention concerne à cet effet un dispositif électromécanique comprenant :
- des première et deuxième électrodes, la première électrode comprenant au moins une première couche métallique et la deuxième électrode comprenant au moins une deuxième couche métallique,
- une couche active comprenant au moins un polymère ferroélectrique, ladite couche active étant disposée entre la première et la deuxième électrode en contact électrique avec lesdites première et deuxième électrodes.

La première électrode et la deuxième électrode comprennent respectivement une première et une deuxième couche d'interface comprenant chacune un poly(3,4-éthylènedioxythiophène), la première et la deuxième couche d'interface s'interposant entre la couche active et respectivement la première et la deuxième couche métallique.

La première et la deuxième couche d'interface s'interposent entre la couche active et respectivement la première et la deuxième couche métallique en séparant ladite couche active desdites première et deuxième couches métalliques de tel manière que la couche active ne rentre pas en contact avec la première et deuxième couches métalliques

Les inventeurs ont découvert que l'une des causes de la détérioration de ces dispositifs électromagnétiques est liée à une réaction entre les électrodes, notamment l'éventuel solvant qu'elles comprennent, et la couche active. En raison de cette réaction, l'interface entre la couche active et lesdites électrodes est dégradée dès la formation du dispositif électromécanique. Cette dégradation est alors amplifiée lors du fonctionnement du dispositif électromécanique et de l'application des contraintes qui sont liées à ce fonctionnement ceci jusqu'à l'apparition des ruptures de connexions des électrodes observées dans l'art antérieur.

Les inventeurs ont ainsi découvert qu'en intégrant à ces dispositifs une couche d'interface comprenant chacune un poly(3,4-éthylènedioxythiophène) entre chaque couche métallique de la première et la deuxième électrode et la couche active, de telle manière qu'elles n'entre pas en contact les unes avec les autres, il est possible de supprimer les réactions entre les électrodes et la couche active. Il en résulte donc une interface de meilleure qualité qui est donc moins susceptible de se dégrader dans la cadre du fonctionnement du dispositif.

De plus, chacune des couches d'interface est flexible, puisqu'elles comprennent chacune un poly(3,4-éthylènedioxythiophène), et dont donc susceptible d'absorber une partie de la déformation transmise par la couche active, réduisant ainsi les contraintes auxquelles sont soumises les première et deuxième électrodes dans le cadre du fonctionnement du dispositif électromagnétique.

De ce fait, le dispositif électromécanique présente une fiabilité accrue vis-à-vis des dispositifs électromagnétiques de l'art antérieur.

Chacun de la première et de la deuxième couche d'interface peut comprendre en outre du poly(styrène sulfonate de sodium), ou du tétraméthylacrylate et/ou du polyaniline.

De cette manière, il est possible d'optimiser la composition de la première et de la deuxième couche et ainsi de fournir une première et une deuxième couche adaptées aux contraintes de fonctionnement du dispositif électromécanique.

L'au moins un polymère ferroélectrique peut être sélectionné parmi un poly(fluorure de vinylidène) et un copolymère poly(fluorure de vinylidène-co-trifluoroéthylène).

De tels polymères présentent de bonnes propriétés piézoélectriques permettant d'optimiser les performances électromécaniques du dispositif.

La première et la deuxième couche métallique peut comprendre au moins l'un parmi des particules métalliques et des fils métalliques, lesdites particules métallique et lesdits fils métalliques étant préférentiellement des particules d'argent et des fils d'argent.

De tels fils ou particules permettent de fournir une bonne conductivité pour appliquer une polarisation à la couche active tout en présentant une flexibilité compatible avec les contraintes mécaniques auxquelles est soumis le dispositif électromécanique.

Au moins l'une de la première et la deuxième électrode peut comprendre en outre, une couche de carbone recouvrant la couche métallique correspondant.

Une telle couche de carbone permet d'absorber au moyen une partie des déformations s'appliquant sur la couche métallique correspondant tout en participant à la conduction électrique de l'électrode correspondante.

La couche active peut comporter une pluralité de portions s'étendant chacune le long d'un plan du dispositif électromécanique parallèlement les unes aux autres, les portions se succédant le long d'une direction perpendiculaire au plan du dispositif, deux portions successives étant au moins partiellement séparée l'une de l'autre par une couche d'électrode intermédiaire comprenant un poly(3,4-éthylènedioxythiophène) appartenant à l'une de la première et la deuxième électrode de telle manière que pour deux couches d'électrode intermédiaire successives, une couche d'électrode intermédiaire est comprise dans la première électrode et l'autre couche d'électrode intermédiaire est comprise dans la deuxième électrode.

Avec une telle configuration, il est possible d'additionner les déformations appliquées par/ou aux portions de couche active de manière à optimiser les performances du dispositif électromécanique selon l'invention.
la couche active peut comporter au moins une première ouverture et au moins une deuxième ouverture pour respectivement la première électrode et la deuxième électrode, la première ouverture s'étendant perpendiculairement au plan du dispositif électromagnétique en interceptant les couches d'électrode intermédiaire d'uniquement la première électrode et la deuxième ouverture s'étendant perpendiculairement au plan du dispositif électromagnétique en interceptant les couche d'électrode intermédiaire d'uniquement la première électrode,
la première électrode comprenant en outre une première interconnexion s'étendant dans la première ouverture en contact avec les couches d'électrode intermédiaire de la première électrode et la deuxième électrode comprenant en outre une deuxième interconnexion s'étendant dans la première ouverture en contact avec les couche d'électrode intermédiaire de la deuxième électrode.

Avec de telles interconnexion aménagées dans une ouverture de la couche active permet de fournir de polariser les couches d'électrode intermédiaire de manière robuste et peu sensible aux déformations auxquelles est soumis la couche active pendant le fonctionnement du dispositif électromécanique.

La première interconnexion et la deuxième interconnexion peuvent comprendre chacune au moins un poly(3,4-éthylènedioxythiophène).

De cette manière, les interconnexions présentent des propriétés élastiques et sont donc particulièrement adaptées pour fournir une polarisation des couches d'électrode intermédiaire même en cas de déformations significatives de la couche active.

Le dispositif électromécanique peut comprendre une première piste métallique connecté à la première électrode et une deuxième piste métallique connectée à la deuxième électrode.

La première couche métallique et la première couche d'interface s'étendent à partir de la première piste métallique en contact avec la couche active et selon une direction perpendiculaire de manière à connecter la première interconnexion et donc les couches d'électrode intermédiaire de la première électrode,
la deuxième couche métallique et la deuxième couche d'interface s'étendent à partir de la deuxième piste métallique en contact avec la couche active et selon une direction perpendiculaire de manière à connecter la deuxième interconnexion et donc les couches d'électrode intermédiaire de la deuxième électrode.

La première piste métallique peut comprendre au moins une première piste de connexion se prolongeant vers une première piste principale, et au moins une première piste secondaire reliant la première électrode à la première piste principale parallèlement à la première piste de connexion,
la deuxième piste métallique comprenant au moins une deuxième piste de connexion se prolongeant vers une première piste principale, et au moins une deuxième piste secondaire reliant la deuxième électrode à la deuxième piste principale parallèlement à la deuxième piste de connexion.

Avec de telles pistes secondaires, la connexion de la première et de la deuxième électrode, en étant redondante, présente peu de risque d'être rompue même en cas de fortes contraintes mécaniques.

Le dispositif électromécanique est choisi dans le groupe comprenant les actionneurs électromagnétiques, les actionneurs ferroélectriques, les capteurs électromécaniques, tels que des capteurs de vibrations, de chocs, ou acoustiques, les dispositifs de récupération d'énergie mécanique, et les composants dual, tel que des capteurs fournissant un retour haptique.

L'invention concerne en outre un procédé de fabrication d'un dispositif électromécanique comprenant les étapes suivantes :
- formation d'une première et deuxième électrodes, la première électrode comprenant au moins une première couche métallique et la deuxième électrode comprenant au moins une deuxième couche métallique,
- formation d'une couche active comprenant un polymère ferroélectrique, ladite couche active étant disposée entre la première et la deuxième électrode en contact électrique avec lesdites première et deuxième électrodes.

Lors de la formation de la première électrode, il est en outre formé une première et une deuxième couche d'interface comprenant chacune un poly(3,4-éthylènedioxythiophène) de tel manière que la première et la deuxième couche d'interface s'interposent entre la couche active et respectivement la première et la deuxième couche métallique en séparant ladite couche active desdites première et deuxième couches métalliques de tel manière que la couche active ne rentre pas en contact avec la première et deuxième couches métalliques.

Un tel procédé permet la fabrication d'un dispositif électromécanique selon l'invention et donc de bénéficier des avantages qui y sont liés.

L'étape de formation des premier et deuxième électrodes peut comprendre les sous étapes suivantes :
- dépôt d'au moins un prépolymère du poly(3,4-éthylènedioxythiophène),
- premier recuit thermique afin de définir la couche d'interface,
- dépôt d'une encre métallique,
- deuxième recuit thermique afin de définir la couche métallique,
- recuit thermique globale, confondu ou non à l'une du premier et du deuxième recuit thermique, pour former chacune de la couche d'interface et de la couche métallique.

L'étape de formation des premier et deuxième électrodes peut comprendre en outre les sous étapes de :
- dépôt d'une encre de carbone,
- troisième recuit thermique afin de définir la couche de carbone, ledit troisième recuit pouvant être ou non confondu avec un recuit thermique global.

### Brève description des dessins

La présente invention sera mieux comprise à la lecture de la description d'exemples de réalisation, donnés à titre purement indicatif et nullement limitatif, en faisant référence aux dessins annexés sur lesquels :
- la figure 1 illustre en vue en coupe schématique une vue de principe d'un dispositif électromécanique selon l'art antérieur,
- les figures 2A et 2B illustrent en vue en coupe un dispositif électromécanique selon respectivement une première et une deuxième configuration de l'art antérieur,
- la figure 3 illustre en vue en coupe schématique une vue de principe d'un dispositif électromécanique selon l'invention,
- la figure 4 illustre en vue en coupe un dispositif selon un premier mode de réalisation de l'invention,
- les figures 5A et 5B illustrent respectivement en vue de dessus et en vue en coupe un dispositif selon un deuxième mode de réalisation de l'invention,
- la figure 6 illustre en vue en coupe un dispositif selon un troisième mode de réalisation de l'invention,

Des parties identiques, similaires ou équivalentes des différentes figures portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

### Description des modes de réalisation

La figure 3 illustre en vue en coupe schématique une vue de principe d'un dispositif électromécanique 10 selon l'invention.

Un tel dispositif électromécanique 10 comprend :
- un support 210,
- des première et deuxième électrodes 220, 230,
- une couche active 240 comprenant au moins un polymère ferroélectrique, ladite couche active 240 étant disposée entre la première et la deuxième électrode 220, 230 en contact électrique avec lesdites première et deuxième électrodes 220, 230.

Selon le principe de l'invention, la première électrode 220 comprend une première couche métallique 221 et une première couche d'interface 225, la première couche d'interface 225 s'interposant entre la couche active 240 et la première couche métallique 221. Une telle configuration dans laquelle la première couche d'interface 225 s'interpose entre la couche active 240 et la première couche métallique 221 permet à la première couche d'interface 225 de séparer la couche active 240 de la couche métallique 221. De cette manière la couche active 240 ne rentre pas en contact avec la première couche métallique 221.

La deuxième électrode 220 comprend une deuxième couche métallique 231 et une deuxième couche d'interface 235, la deuxième couche d'interface 235 s'interposant entre la couche active 240 et la première couche métallique 231. Une telle configuration dans laquelle la deuxième couche d'interface 235 s'interpose entre la couche active 240 et la deuxième couche métallique 231 permet à la deuxième couche d'interface 225 de séparer la couche active 240 de la deuxième couche métallique 231. De cette manière la couche active 240 ne rentre pas non plus en contact avec la deuxième couche métallique 231.

La deuxième couche d'électrode 220 comprend en outre, comme illustré sur la figure 3, une deuxième couche de carbone 238, telle qu'une couche de graphène ou de graphite, afin de passiver les parties de la deuxième couche métallique 231 qui ne sont pas en contact avec la deuxième couche d'interface 235.

Ainsi, plus précisément, le support 210 peut être, par exemple, un support en verre ou en quartz ou encore une surface de circuit imprimé flexible, tel qu'un support en polyimide ou en PolyEtherEtherKetone, plus connu sous l'abréviation PEEK. Le support peut également être un polycarbonate, PC ou un poly(naphtalate d'éthylène), PEN, ou encore un support papier.

La première couche métallique 221 est, selon la configuration illustrée sur la figure 3, disposée en contact avec le support 210 en étant reliée avec une piste conductrice non figurée.

La première couche métallique 221 peut comprendre au moins l'un parmi des particules métalliques, telles que des particules d'argent, et des fils métalliques, tels que des fils d'argent. La première couche métallique 221 peut ainsi, par exemple, être une couche métallique réalisée par dépôt d'une encre métallique comprenant lesdites particules métalliques et/ou fils métalliques et un solvant. Dans une application particulièrement avantageuse de l'invention, la première couche métallique peut être réalisée à partir d'une encre d'argent comprenant des particules d'argent et/ou des fils d'argent. La première couche métallique 221 peut présenter une épaisseur comprise entre 500 nm et 15 µm, celle-ci étant préférentiellement comprise entre 1 µm et 7,5 µm voire entre 2 µm et 4 µm. Ainsi la première couche métallique 221 peut avantageusement présenter une épaisseur de 3 µm.

La première couche métallique 221 est recouverte par la première couche d'interface 225.

La première couche d'interface 225 comprend un poly(3,4-éthylènedioxythiophène). Ainsi la première couche d'interface 225 peut être constituer du seul poly(3,4-éthylènedioxythiophène), plus connu sous l'abréviation PEDOT ou peut comprendre en alliage comprenant du PEDOT, tel qu'un alliage de poly(3,4-éthylènedioxythiophène) et de poly(styrène sulfonate de sodium), plus connu sous l'abréviation PEDOT-PSS, un alliage de poly(3,4-éthylènedioxythiophène) et de tétraméthylacrylate, plus connu sous l'abréviation PEDOT-TMA, un alliage de poly(3,4-éthylènedioxythiophène) et de polyaniline, plus connu sous l'abréviation PEDOT-PANI.

La première couche d'interface 255 présente une épaisseur comprise entre 200 nm et 3 µm, préférentiellement comprise entre 500 nm et 2 µm, voire entre 750 nm et 1.5 µm. La première couche d'interface 225 peut ainsi avantageusement présenter une épaisseur de 1 µm.

La première couche d'interface 225, s'interposant entre la première couche métallique 221 et la couche active 240, elle est recouverte par la couche active 240.

La couche active 240 est une couche comprenant au moins un polymère ferroélectrique tel qu'un poly(fluorure de vinylidène) ou un copolymère poly(fluorure de vinylidène-co-trifluoroéthylène).

La couche active 240 est elle-même recouverte par la deuxième électrode 230 ceci de manière que la couche active 240 soit disposée entre la première et la deuxième électrode 220, 230 en contact électrique avec lesdites première et deuxième électrodes 220, 230.

La deuxième couche d'interface 235 et la deuxième couche métallique 231 présentent une configuration similaire à respectivement la première couche d'interface225 et la première couche métallique 221.

Qui plus est, la deuxième électrode 220 comprend en outre la deuxième couche de carbone 238 qui recouvre la couche métallique 231 sur la surface de cette dernière qui est libre de deuxième couche d'interface 225. La couche de carbone 228 présente une épaisseur comprise entre 1 µm et 15 µm, préférentiellement entre 3 µm et 12 µm, voire entre 5 µm et 10 µm. La deuxième couche de carbone 238 peut ainsi avantageusement présenter une épaisseur de 1 µm.

Un tel dispositif électromécanique 20 selon le principe de l'invention peut être réalisé à partir d'un procédé de fabrication comprenant les étapes suivantes :
- fourniture du support 210,
- formation de la première électrode 220 en contact avec le support 210,
- formation de la couche active 240 en contact avec la première électrode,
- formation de la deuxième électrode 230 en contact avec la couche active.

Dans un tel procédé de fabrication, l'étape de formation de la première électrode 220 peut comprendre les sous-étapes suivantes :
- dépôt de la première couche métallique 221 ceci par, par exemple, sérigraphie d'une encre métallique telle qu'une encre d'argent,
- un premier recuit thermique de la première couche métallique 221 afin de définir la première couche métallique 221,
- dépôt d'un prépolymère pour la formation du poly(3,4-éthylènedioxythiophène) ou de l'alliage le comportant en contact de la première couche métallique 221,
- un deuxième recuit thermique afin de prépolymériser le prépolymère et définir la première couche d'interface 225.

On notera que la formation de la première électrode 220 est compléter par un recuit globale permettant de notamment d'obtenir la polymérisation de la première couche d'interface 225.

L'étape de formation de la couche active 240 peut comprendre les sous-étapes suivantes :
- dépôt d'un prépolymère de l'au moins un polymère ferroélectrique,
- un troisième recuit thermique de manière à définir la couche active 240.

L'étape de formation de la deuxième électrode 230 peut comprendre les sous-étapes suivantes :
- dépôt d'un prépolymère pour la formation du poly(3,4-éthylènedioxythiophène) ou de l'alliage le comportant en contact de la couche active 240, ce dépôt étant réalisé, par exemple, par sérigraphie,
- un quatrième recuit thermique afin de prépolymériser le prépolymère et définir la deuxième couche d'interface 235,
- dépôt de la deuxième couche métallique 231 en contact de la deuxième couche d'interface 235, ceci par, par exemple, sérigraphie d'une encre métallique telle qu'une encre d'argent,
- un cinquième recuit thermique de la deuxième couche métallique 231 afin de définir la deuxième couche métallique 231,
- dépôt de carbone en contact de la deuxième couche métallique 231, ledit dépôt pouvant être réalisé par sérigraphie d'une encre carbone telle qu'une encre de graphite ou une encre de graphène,
- recuit global afin de former la deuxième couche de carbone 238 à partir du carbone déposé et les première et deuxième couche métallique 221, 213 et de polymériser la couche active 240 et les première et deuxième couche d'interface 225, 235 afin de les former.

Ainsi, après ce dernier recuit global le dispositif électromécanique 20 est formé.

Les premier au cinquième recuits thermiques peuvent par exemple être des recuits d'une durée comprise entre 3 min et 5 min à une température comprise entre 100°C et 120°C. Le recuit global peut être, par exemple, un recuit d'une durée de 30 min à une température de 150°C.

La figure 4 illustre en vue en coupe un dispositif électromécanique 10A selon un premier mode de réalisation pratique de l'invention dans lequel la couche active 240 présente une configuration en multi-étages, similaire à celles de l'art antérieur illustré sur les figures 2A et 2B ceci de manière à optimiser les performances du dispositif électromécanique 10A.

Un tel dispositif électromécanique 10A présente ainsi la couche active 240 comportant une pluralité de portions 241s'étendant chacune le long d'un plan du dispositif électromécanique parallèlement les unes aux autres, les portions 241 se succédant le long d'une direction perpendiculaire au plan du dispositif. Deux portions 241 successives la couche active sont au moins partiellement séparées l'une de l'autre par une couche d'électrode intermédiaire 226, 236 appartenant à l'une de la première et la deuxième électrode 220, 230 de telle manière que pour deux couches d'électrode intermédiaire successives 226, 236, une couche d'électrode intermédiaire 226 est comprise dans la première électrode 220 et l'autre couche d'électrode intermédiaire 236 est comprise dans la deuxième électrode 230.

Afin de permettre une connexion des couches d'électrode intermédiaire 226, 236, la couche active 240 comporte au moins une première ouverture 242 et au moins une deuxième ouverture 243 pour respectivement la première électrode 220 et la deuxième électrode 230. La première ouverture 242 s'étend perpendiculairement au plan du dispositif électromagnétique 20A en interceptant les couches d'électrode intermédiaire 226 d'uniquement la première électrode 220. La deuxième ouverture 243 s'étend perpendiculairement au plan du dispositif électromagnétique 20 en interceptant les couches d'électrode intermédiaire 236 d'uniquement la première électrode 230.

La première électrode 220 comprend en outre une première interconnexion 227 s'étendant dans la première ouverture 242 en contact avec les couches d'électrode intermédiaire 226 de la première électrode 220. De même, la deuxième électrode 230 comprend en outre une deuxième interconnexion 237 s'étend dans la deuxième ouverture 243 en contact avec les couches d'électrode intermédiaire 236 de la deuxième électrode 230.

Dans ce présent mode de réalisation la première interconnexion 227 et la deuxième interconnexion sont constituées de PEDOT ou d'un alliage comprenant du PEDOT ou d'un alliage tel qu'un alliage PEDOT-PSS, PEDOT-TMA ou PEDOT-PANI.

D'une même manière, chacune des couches d'électrode intermédiaire 226, 236 sont constituées de PEDOT ou d'un alliage comprenant du PEDOT ou d'un alliage tel qu'un alliage PEDOT-PSS, PEDOT-TMA ou PEDOT-PANI.

Afin de permettre une connexion de la première interconnexion 227, la première électrode 220 comprend la première couche d'interface 225, la première couche métallique 221 et une première couche de carbone 228. La première couche d'interface 225, la première couche métallique 221 et la première couche de carbone s'étendent à partir d'au moins une première piste métallique 252 du support 210 en contact avec un côté de la couche active 240 et selon une direction perpendiculaire de manière à connecter la première interconnexion 227 et donc les couche d'électrode intermédiaire 226 de la première électrode 220.

Dans une telle configuration, conformément à l'invention, la première couche d'interface 225 est en contact avec la couche active 240, la première couche métallique 221 étant en contact avec la première couche d'interface 225 et la première couche de carbone 228 recouvrant la surface de la première couche métallique 221 libre de première couche d'interface 225.

La deuxième électrode 230, présentant une configuration similaire à celle de la première électrode 220, elle comporte la deuxième couche d'interface 235, la deuxième couche métallique 231 et la deuxième couche de carbone 238. Les couches 235, 231, 238 de la deuxième électrode s'étendent à partir d'au moins une deuxième piste métallique 253 du support 210 en contact avec un côté de la couche active 240 et selon une direction perpendiculaire de manière à connecter la deuxième interconnexion 237 et donc les couche d'électrode intermédiaire 236 de la deuxième électrode 230.

La deuxième couche d'interface 235 est en contact avec la couche active 240, la deuxième couche métallique 231 étant en contact avec la deuxième couche d'interface 235 et la deuxième couche de carbone 238 recouvrant la surface de la deuxième couche métallique 231 libre de deuxième couche d'interface 235.

Ainsi, avec une telle configuration, l'utilisation d'interconnexions 227, 237 aménagées dans la couche active 240 permet d'assurer une connexion robuste des couches d'électrode intermédiaire 226, 236.

Un procédé de fabrication d'un dispositif électromécanique 10A selon ce premier mode de réalisation se différencie d'un procédé de fabrication d'un dispositif électromécanique 10 selon le principe de l'invention en ce que :
- lors de l'étape de formation de la couche active 240, la couche active 240 présente les première et deuxième ouvertures 242, 243 et il est prévu des sous étapes suivantes reproduite successivement jusqu'à la formation de la couche active 240 de :
   ∘ dépôt d'un prépolymère de l'au moins un polymère ferroélectrique correspondant à une portion 241 de la couche active 240,
   ∘ un premier recuit thermique intermédiaire de manière à définir la portion 241 de couche active 240,
   ∘ dépôt d'un prépolymère du poly(3,4-éthylènedioxythiophène) ou de l'alliage le comportant en contact de ladite portion 241 de couche active 240,
   ∘ un deuxième recuit thermique intermédiaire de manière à définir une couche d'électrode intermédiaire 226, 236,
- les étapes de formation de la première et de la deuxième électrode 220, 230 sont postérieures à l'étape de formation de la de la couche active 240 et sont réalisées en parallèle l'une à l'autre,
- les étapes de formation de la première et de la deuxième électrode 220, 230 comprennent :
   ∘ dépôt du prépolymère du poly(3,4-éthylènedioxythiophène) ou de l'alliage le comportant en contact en contact d'un premier et d'un deuxième côté de la première couche active et dans les première et deuxième ouvertures 242, 243, ce dépôt étant réalisé, par exemple, par sérigraphie,
   ∘ un premier recuit thermique afin de prépolymériser le prépolymère et définir les première et deuxième couches d'interface 225,235 et les première et deuxième interconnexions,
   ∘ dépôt de la première et de la deuxième couche métallique 221, 231 en contact de respectivement la première et la deuxième couche d'interface 225, 235, ceci, par exemple, par sérigraphie d'une encre métallique telle qu'une encre d'argent,
   ∘ un deuxième recuit thermique de la première et de la deuxième couche métallique 221, 231 afin de définir respectivement la première et la deuxième couche métallique 221, 231,
   ∘ dépôt de carbone en contact de la première et de la deuxième couche métallique 221, 231, ledit dépôt pouvant être réalisé par sérigraphie d'une encre carbone, une encre de graphite ou une encre de graphène,
   ∘ recuit global afin de former les première et deuxième couches de carbone 238 à partir du carbone déposé et les première et deuxième couches métalliques 221, 213 et polymériser la couche active 240, les première et deuxième couche d'interface 225, 235, les première et deuxième interconnexions 227, 237 et les couches d'électrodes intermédiaires 226, 236.

D'une manière similaire au procédé de fabrication d'un dispositif électromécanique 10 selon le principe de l'invention, les premier et deuxième recuits thermiques et les premiers et deuxièmes recuits thermiques intermédiaires peuvent être des recuits d'une durée comprise entre 3 min et 5 min à une température comprise entre 100°C et 120°C. Le recuit global peut être, par exemple, un recuit d'une durée de 30 min à une température de 150°C.

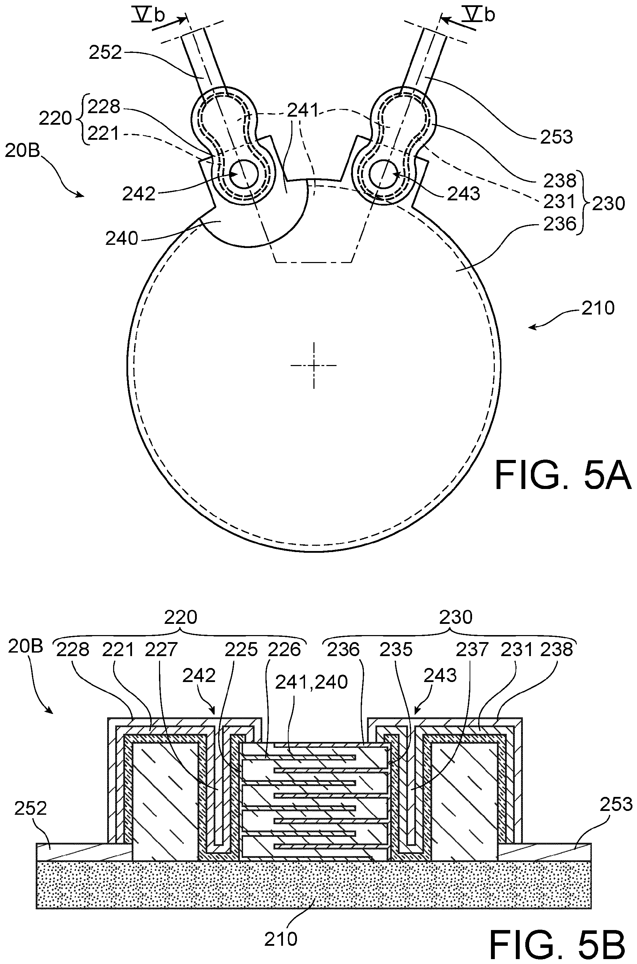

Les figures 5A et 5B illustrent en vue en coupe un dispositif électromécanique 10B selon un deuxième mode de réalisation pratique de l'invention dans lequel les première et deuxième interconnexions 227, 237 présentent une conformation multi-étages similaire au reste de la première et deuxième électrode.

Un dispositif électromécanique 10B selon un deuxième mode de réalisation se différencie d'un dispositif électromécanique 10A selon le premier mode de réalisation uniquement par configuration de la première et de la deuxième interconnexion 227, 237.

On notera que, conformément à l'illustration de la figure 5A qui montre le dispositif électromécanique 10B selon ce deuxième mode de réalisation, que les première et deuxième pistes métallique 252, 253 sont disposées côte à côte de manière à disposer les première et deuxième couche métallique 221, 231 sur un même côté de la couche active 240. Un tel arrangement permet de contraindre le déplacement de la couche active 240 que sur un côté, celui utilisé pour sa connexion, permettant d'optimiser les performances ferroélectrique à l'opposé de cette prise de contact.

Ainsi, dans un tel dispositif électromécanique 10B, la première et la deuxième ouverture 242, 243 sont dimensionnées afin d'accueillir à la fois la première/deuxième couche d'interface 225/235, la première/ deuxième couche métallique 221/231 et la première/deuxième couche de carbone 228/238.

De ce fait, comme montré sur la figure 5B, la première interconnexion 227 comprend :
- une portion de la première couche d'interface 225 en contact avec la couche active 240, et donc des couche d'électrode intermédiaire 226 correspondant à la première électrode 220, sur la paroi intérieure de la première ouverture 242,
- une portion de la première couche métallique 221 en contact avec la portion de la première couche d'interface 225,
- une portion de la première couche de carbone 228 recouvrant les parties de la portion de première couche métallique 221 libre de première couche d'interface 225.

D'une manière identique, la deuxième interconnexion 237 comprend :
- une portion de la deuxième couche d'interface 235 en contact avec la couche active 240, et donc des couche d'électrode intermédiaire 236 correspondant à la première électrode 230, sur la paroi intérieure de la deuxième ouverture 243,
- une portion de la deuxième couche métallique 231 en contact avec la portion de la deuxième couche d'interface 235,
- une portion de la deuxième couche de carbone 238 recouvrant les parties de la portion de deuxième couche métallique 231 libre de première couche d'interface 235.

Avec une telle configuration, on assure à la fois une bonne tenue mécanique des première et deuxième interconnexion 227, 237 lors du fonctionnement de la structure électromécanique 10B et une bonne connexion électrique entre les couches d'électrode intermédiaire 226, 236 et les pistes métalliques 252, 253.

Un procédé de fabrication d'un dispositif électromécanique 10B selon ce deuxième mode de réalisation pratique de l'invention se différencie d'un procédé de fabrication du dispositif électromécanique 10A selon le premier mode de réalisation pratique de l'invention en ce que :
- lors de la formation de la couche active 240, les premier et deuxième ouverture 242, 243 présentent, dans le plan du dispositif électromécanique 2 une section latérale dont la dimension minimale est supérieure ou égale à la somme du double des épaisseurs de la première couche d'interface 225 et de la première couche métallique 221,
- lors de la formation des première et deuxième électrode, le dépôt de la première et de la deuxième couche métallique 221, 231 et le dépôt de carbone sont également réalisé dans les première et deuxième ouverture 242, 243 en contact de respectivement la première et la deuxième couche d'interface 225, 235 et de la première et deuxième couche métallique 221, 231.

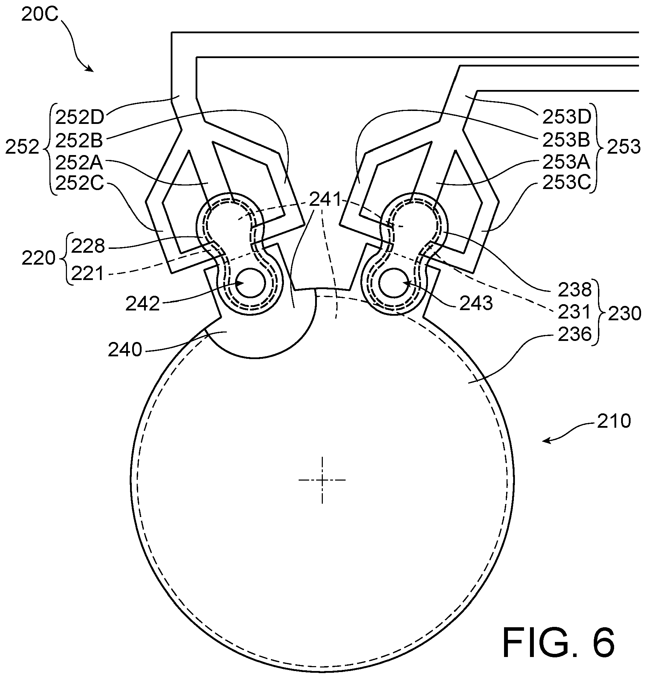

La figure 6 illustre une vue de dessus d'un dispositif électromécanique 10C selon une variante de ce deuxième mode pratique de l'invention dans lequel la première et la deuxième piste métallique 252, 253 sont redondantes afin d'assurer une connexion de l'électrode en cas de rupture de la piste au niveau de l'électrode 220, 230.

Ainsi, un dispositif électromécanique 10C selon cette variante se différencie du dispositif électromécanique 10B selon le deuxième mode de réalisation pratique de l'invention en ce que la première et la deuxième piste mécanique 252 et 253 présente une configuration redondante.

Comme illustré sur la figure 6, la première piste métallique 252 comprend :
- une première piste de connexion 252A, s'étendant à partir de la première électrode 220 et se prolongeant vers une première piste principale 252D,
- une première et une deuxième piste secondaire 252B, 252C, s'étendant à partir de la première électrode 220 de part est d'autre de la première piste de connexion 252A pour connecter la première piste principale252D,
- la première piste de connexion principale 252D.

D'une manière identique, la deuxième piste métallique 253 comprend :
- une deuxième piste de connexion 253A, s'étendant à partir de la deuxième électrode 230 et se prolongeant vers une première piste principale 253D,
- une troisième et une quatrième piste secondaire 253B, 253C, s'étendant à partir de la deuxième électrode 230 de part est d'autre de la deuxième piste de connexion 253A pour connecter la première piste principale252D,
- la deuxième piste de connexion principale 253D.

## Revendications

1. Dispositif électromécanique (20, 20A, 20B, 20C) comprenant :
- des première et deuxième électrodes (220, 230), la première électrode (220) comprenant au moins une première couche métallique (221) et la deuxième électrode (230) comprenant au moins une deuxième couche métallique (231),
- une couche active (240) comprenant au moins un polymère ferroélectrique, ladite couche active (240) étant disposée entre la première et la deuxième électrode (220, 230) en contact électrique avec lesdites première et deuxième électrodes (220, 230),
le dispositif électromécanique (20, 20A, 20B, 20C) **étant caractérisé en ce que** la première électrode et la deuxième électrode (220, 230) comprennent respectivement une première et une deuxième couche d'interface (225, 235) comprenant chacune du poly(3,4-éthylènedioxythiophène), la première et la deuxième couche d'interface (225, 235) s'interposant entre la couche active (240) et respectivement la première et la deuxième couche métallique (221, 231) en séparant ladite couche active (240) desdites première et deuxième couches métalliques (221, 231) de tel manière que la couche active (240) ne rentre pas en contact avec la première et deuxième couches métalliques (221, 231).

2. Dispositif électromécanique (20) selon la revendication 1, dans lequel chacun de la première et de la deuxième couche d'interface comprend en outre du poly(styrène sulfonate de sodium),du tétraméthylacrylate et/ou du polyaniline.

3. Dispositif électromécanique (20) selon l'une quelconque des revendications 1 ou 2, dans lequel l'au moins un polymère ferroélectrique est sélectionné parmi un poly(fluorure de vinylidène) et un copolymère poly(fluorure de vinylidène-co-trifluoroéthylène).

4. Dispositif électromécanique (20) selon la revendication 1 ou 2, dans lequel la première et la deuxième couche métallique (221, 231) comprend au moins l'un parmi des particules métalliques et des fils métalliques, lesdites particules métallique et lesdits fils métalliques étant préférentiellement des particules d'argent et des fils d'argent.

5. Dispositif électromécanique (20) selon l'une quelconque des revendications 1 à 4, dans lequel au moins l'une de la première et la deuxième électrode (220, 230) comprend en outre, une couche de carbone (228, 238) recouvrant la couche métallique (221, 231) correspondant.

6. Dispositif électromécanique (20) selon l'une quelconque des revendications 1 à 5, dans laquelle la couche active (240) comporte une pluralité de portions (241) s'étendant chacune le long d'un plan du dispositif électromécanique parallèlement les unes aux autres, les portions (241) se succédant le long d'une direction perpendiculaire au plan du dispositif, deux portions (241) successives étant au moins partiellement séparée l'une de l'autre par une couche d'électrode intermédiaire (226, 236) comprenant un poly(3,4-éthylènedioxythiophène) appartenant à l'une de la première et la deuxième électrode (220, 230) de telle manière que pour deux couches d'électrode intermédiaire successives (226, 236), une couche d'électrode intermédiaire (226) est comprise dans la première électrode (220) et l'autre couche d'électrode intermédiaire (236) est comprise dans la deuxième électrode (230).

7. Dispositif électromécanique (20) selon la revendication 6, dans lequel la couche active (240) comporte au moins une première ouverture (242) et au moins une deuxième ouverture (243) pour respectivement la première électrode (220) et la deuxième électrode (230), la première ouverture (242) s'étendant perpendiculairement au plan du dispositif électromagnétique (20) en interceptant les couches d'électrode intermédiaire (226) d'uniquement la première électrode (220) et la deuxième ouverture (243) s'étendant perpendiculairement au plan du dispositif électromagnétique (20) en interceptant les couche d'électrode intermédiaire (236) d'uniquement la première électrode (230),
la première électrode (220) comprenant en outre une première interconnexion (227) s'étendant dans la première ouverture en contact avec les couche d'électrode intermédiaire (226) de la première électrode (220) et la deuxième électrode (230) comprenant en outre une deuxième interconnexion (237) s'étendant dans la première ouverture en contact avec les couche d'électrode intermédiaire (236) de la deuxième électrode (230).

8. Dispositif électromécanique (20) selon la revendication 7, dans lequel la première interconnexion (227) et la deuxième interconnexion (237) comprennent chacune au moins un poly(3,4-éthylènedioxythiophène).

9. Dispositif électromécanique (20) selon l'une quelconque des revendications 1 à 8, comprenant en outre une première piste métallique (252) connecté à la première électrode (220) et une deuxième piste métallique (253) connectée à la deuxième électrode (230).

10. Dispositif électromécanique (20) selon la revendication 9 prise en combinaison avec la revendication 7 ou 8 dans lequel la première couche métallique (221) et la première couche d'interface (225) s'étendent à partir de la première piste métallique (252) en contact avec la couche active (240) et selon une direction perpendiculaire de manière à connecter la première interconnexion (227) et donc les couche d'électrode intermédiaire (226) de la première électrode (220),
la deuxième couche métallique (231) et la deuxième couche d'interface (235) s'étendent à partir de la deuxième piste métallique (253) en contact avec la couche active (240) et selon une direction perpendiculaire de manière à connecter la deuxième interconnexion (237) et donc les couches d'électrode intermédiaire (236) de la deuxième électrode (230).

11. Dispositif électromécanique selon la revendication 9 seule ou en combinaison avec la revendication 10, dans lequel la première piste métallique (252) comprend une première piste principale (252E), au moins une première piste de connexion (252B) se prolongeant vers la première piste principale (252E) pour relier la première piste principale (252E) à la première électrode (220), et au moins une première piste secondaire (252C, 252D) reliant la première électrode (220) à la première piste principale (252E) parallèlement à la première piste de connexion (252B),
et dans lequel la deuxième piste métallique (253) comprend une deuxième piste principale (253E), au moins une deuxième piste de connexion (253B) se prolongeant vers la première piste principale (253E) pour relier la deuxième piste principale (252E) à la deuxième électrode (220), et au moins une deuxième piste secondaire (253C, 253D) reliant la deuxième électrode (230) à la deuxième piste principale (253E) parallèlement à la deuxième piste de connexion (253B).

12. Procédé de fabrication d'un dispositif électromécanique comprenant les étapes suivantes :
- formation d'une première et deuxième électrodes (220, 230), la première électrode (220) comprenant au moins une première couche métallique (221) et la deuxième électrode (230) comprenant au moins une deuxième couche métallique (231),
- formation d'une couche active (240) comprenant un polymère ferroélectrique, ladite couche active (240) étant disposée entre la première et la deuxième électrode (220, 230) en contact électrique avec lesdites première et deuxième électrodes (220, 230),
le procédé de fabrication étant **caractérisé en ce que** lors de la formation de la première électrodes il est en outre formé une première et une deuxième couche d'interface (225, 235) comprenant chacune un poly(3,4-éthylènedioxythiophène) de tel manière que la première et la deuxième couche d'interface (225, 235) s'interposent entre la couche active (240) et respectivement la première et la deuxième couche métallique (221, 231) en séparant ladite couche active (240) desdites première et deuxième couches métalliques (221, 231) de tel manière que la couche active (240) ne rentre pas en contact avec la première et deuxième couches métalliques (221, 231).

13. Procédé de fabrication selon la revendication 12, dans lequel l'étape de formation des premier et deuxième électrodes (220, 230) comprend les sous étapes suivantes :
- dépôt d'au moins un prépolymère du poly(3,4-éthylènedioxythiophène),
- premier recuit thermique afin de définir la couche d'interface,
- dépôt d'une encre métallique,
- deuxième recuit thermique afin de définir la couche métallique,
- recuit thermique globale, confondu ou non à l'une du premier et du deuxième recuit thermique, pour former chacune de la couche d'interface et de la couche métallique.

14. Procédé de fabrication selon l'une quelconque la revendication 12 ou 13, dans lequel l'étape de formation des premier et deuxième électrodes (220, 230) comprend en outre les sous étapes de :
- dépôt d'une encre de carbone,
- troisième recuit thermique afin de définir la couche de carbone, ledit troisième recuit pouvant être ou non confondu avec un recuit thermique global.

## Patentansprüche

1. Elektromechanische Vorrichtung (20, 20A, 20B, 20C), umfassend:
- erste und zweite Elektroden (220, 230), wobei die erste Elektrode (220) mindestens eine erste Metallschicht (221) umfasst und die zweite Elektrode (230) mindestens eine zweite Metallschicht (231) umfasst,
- eine aktive Schicht (240), mindestens ein ferroelektrisches Polymer umfassend, wobei die aktive Schicht (240) zwischen der ersten und der zweiten Elektrode (220, 230) angeordnet ist in elektrischem Kontakt mit der ersten und zweiten Elektrode (220, 230),
wobei die elektromechanische Vorrichtung (20, 20A, 20B, 20C) **dadurch gekennzeichnet ist, dass** die erste Elektrode und die zweite Elektrode (220, 230) jeweils eine erste und eine zweite Schnittstellenschicht (225, 235) umfassen, die jeweils Poly(3,4-Ethylendioxythiophen) umfassen, wobei die erste und die zweite Schnittstellenschicht (225, 235) zwischen der aktiven Schicht (240) und jeweils der ersten und zweiten Metallschicht (221, 231) positioniert sind, die aktive Schicht (240) von der ersten und zweiten Metallschicht (221, 231) trennend, so dass die aktive Schicht (240) nicht mit der ersten und zweiten Metallschicht (221, 231) in Kontakt kommt.

2. Elektromechanische Vorrichtung (20) nach Anspruch 1, wobei jede der ersten und der zweiten Schnittstellenschicht ferner Poly(Styrolsulfonat-Natrium), Tetramethylacrylat und/oder Polyanilin umfasst.

3. Elektromechanische Vorrichtung (20) nach einem der Ansprüche 1 oder 2, wobei mindestens ein ferroelektrisches Polymer aus einem Poly(Vinylidenfluorid) und einem Copolymer Poly(Vinylidenfluorid-co-Trifluorethylen) ausgewählt wird.

4. Elektromechanische Vorrichtung (20) nach Anspruch 1 oder 2, wobei die erste und die zweite Metallschicht (221, 231) mindestens Metallpartikel und/oder Metalldrähte umfassen, wobei die Metallpartikel und die Metalldrähte vorzugsweise Silberpartikel und Silberdrähte sind.

5. Elektromechanische Vorrichtung (20) nach einem der Ansprüche 1 bis 4, wobei mindestens eine der ersten und der zweiten Elektrode (220, 230) ferner eine Kohlenstoffschicht (228, 238) umfasst, die die entsprechende Metallschicht (221, 231) bedeckt.

6. Elektromechanische Vorrichtung (20) nach einem der Ansprüche 1 bis 5, wobei die aktive Schicht (240) eine Vielzahl von Abschnitten (241) beinhaltet, die sich jeweils entlang einer Ebene der elektromechanischen Vorrichtung parallel zueinander erstrecken, wobei sich die Abschnitte (241) entlang einer Richtung senkrecht zur Ebene der Vorrichtung aufeinanderfolgen, wobei zwei aufeinanderfolgende Abschnitte (241) mindestens teilweise durch eine Elektrodenzwischenschicht (226, 236) voneinander getrennt sind, die ein Poly(3,4-Ethylendioxythiophen) umfasst, das zu einer der ersten und der zweiten Elektrode (220, 230) gehört, so dass für zwei aufeinanderfolgende Elektrodenzwischenschichten (226, 236) eine Elektrodenzwischenschicht (226) in der ersten Elektrode (220) enthalten ist und die andere Elektrodenzwischenschicht (236) in der zweiten Elektrode (230) enthalten ist.

7. Elektromechanische Vorrichtung (20) nach Anspruch 6, wobei die aktive Schicht (240) mindestens eine erste Öffnung (242) und mindestens eine zweite Öffnung (243) beinhaltet für die jeweils erste Elektrode (220) und die zweite Elektrode (230), wobei sich die erste Öffnung (242) senkrecht zur Ebene der elektromagnetischen Vorrichtung (20) erstreckt, nur die Elektrodenzwischenschichten (226) der ersten Elektrode (220) schneidend, und sich die zweite Öffnung (243) senkrecht zur Ebene der elektromagnetischen Vorrichtung (20) erstreckt, nur die Elektrodenzwischenschichten (236) der ersten Elektrode (230) schneidend,
wobei die erste Elektrode (220) ferner eine erste Vernetzung (227) umfasst, die sich in die erste Öffnung in Kontakt mit der Elektrodenzwischenschicht (226) der ersten Elektrode (220) erstreckt, und die zweite Elektrode (230) ferner eine zweite Vernetzung (237) umfasst, die sich in die erste Öffnung in Kontakt mit der Elektrodenzwischenschicht (236) der zweiten Elektrode (230) erstreckt.

8. Elektromechanische Vorrichtung (20) nach Anspruch 7, wobei die erste Vernetzung (227) und die zweite Vernetzung (237)jeweils mindestens ein Poly(3,4-Ethylendioxythiophen) umfassen.

9. Elektromechanische Vorrichtung (20) nach einem der Ansprüche 1 bis 8, ferner eine erste Metallbahn (252) umfassend, die mit der ersten Elektrode (220) verbunden ist, und eine zweite Metallbahn (253), die mit der zweiten Elektrode (230) verbunden ist.

10. Elektromechanische Vorrichtung (20) nach Anspruch 9 in Kombination mit Anspruch 7 oder 8, wobei sich die erste Metallschicht (221) und die erste Schnittstellenschicht (225) von der ersten Metallbahn (252) in Kontakt mit der aktiven Schicht (240) erstrecken und in einer senkrechten Richtung, so dass die erste Vernetzung (227) verbunden ist und damit die Elektrodenzwischenschichten (226) der ersten Elektrode (220),
wobei sich die zweite Metallschicht (231) und die zweite Schnittstellenschicht (235) von der zweiten Metallbahn (253) in Kontakt mit der aktiven Schicht (240) erstrecken und in einer senkrechten Richtung, so dass die zweite Vernetzung (237) verbunden ist und damit die Elektrodenzwischenschichten (236) der zweiten Elektrode (230).

11. Elektromechanische Vorrichtung nach Anspruch 9 allein oder in Kombination mit Anspruch 10, wobei die erste Metallbahn (252) eine erste Hauptbahn (252E) umfasst und mindestens eine erste Verbindungsbahn (252B), die sich zur ersten Hauptbahn (252E) verlängert, um die erste Hauptbahn (252E) an die erste Elektrode (220) anzuschließen, und mindestens eine erste Sekundärbahn (252C, 252D), die die erste Elektrode (220) an die erste Hauptbahn (252E) parallel zur ersten Verbindungsbahn (252B) anschließt,
und wobei die zweite Metallbahn (253) eine zweite Hauptbahn (253E) umfasst und mindestens eine zweite Verbindungsbahn (253B), die sich zur ersten Hauptbahn (253E) verlängert, um die zweite Hauptbahn (252E) an die zweite Elektrode (220) anzuschließen, und mindestens eine zweite Sekundärbahn (253C, 253D), die die zweite Elektrode (230) an die zweite Hauptbahn (253E) parallel zur zweiten Verbindungsbahn (253B) anschließt.

12. Herstellungsverfahren einer elektromechanischen Vorrichtung, die folgenden Schritte umfassend:
- Bildung einer ersten und zweiten Elektrode (220, 230), wobei die erste Elektrode (220) mindestens eine erste Metallschicht (221) umfasst und die zweite Elektrode (230) mindestens eine zweite Metallschicht (231) umfasst,
- Bildung einer aktiven Schicht (240), ein ferroelektrisches Polymer umfassend, wobei die aktive Schicht (240) zwischen der ersten und der zweiten Elektrode (220, 230) angeordnet ist in elektrischem Kontakt mit der ersten und zweiten Elektrode (220, 230),
wobei das Herstellungsverfahren **dadurch gekennzeichnet ist, dass** während der Bildung der ersten Elektroden ferner eine erste und eine zweite Schnittstellenschicht (225, 235) gebildet wird, die jeweils ein Poly(3,4-Ethylendioxythiophen) umfassen, so dass die erste und die zweite Schnittstellenschicht (225, 235) zwischen der aktiven Schicht (240) und jeweils der ersten und der zweiten Metallschicht (221, 231) positioniert sind, die aktive Schicht (240) von der ersten und zweiten Metallschicht (221, 231) trennend, so dass die aktive Schicht (240) nicht mit der ersten und zweiten Metallschicht (221, 231) in Kontakt kommt.

13. Herstellungsverfahren nach Anspruch 12, wobei der Schritt der Bildung der ersten und zweiten Elektroden (220, 230) die folgenden Zwischenschritte umfasst:
- Ablagerung von mindestens einem Prepolymer des Poly(3,4-Ethylendioxythiophen),
- erstes thermisches Glühen, um die Schnittstellenschicht zu definieren,
- Ablagerung einer metallischen Tinte,
- zweites thermisches Glühen, um die Metallschicht zu definieren,
- gesamtes thermisches Glühen, mit einem des ersten und des zweiten thermischen Glühens kombiniert oder nicht, um jedes eine Schnittstellenschicht und eine Metallschicht zu bilden.

14. Herstellungsverfahren nach einem der Ansprüche 12 oder 13, wobei der Schritt der Bildung der ersten und zweiten Elektroden (220, 230) ferner die Zwischenschritte umfasst:
- Ablagerung einer Kohlenstofftinte,
- drittes thermisches Glühen, um die Kohlenstoffschicht zu definieren, wobei das dritte Glühen mit einem gesamten thermischen Glühen kombiniert werden kann oder nicht.

## Claims

1. An electromechanical device (20, 20A, 20B, 20C) comprising:
- first and second electrodes (220, 230), the first electrode (220) comprising at least a first metal layer (221) and the second electrode (230) comprising at least a second metal layer (231),
- an active layer (240) comprising at least one ferroelectric polymer, the active layer (240) being disposed between the first and the second electrode (220, 230) in electrical contact with said first and second electrodes (220, 230),
the electromechanical device (20, 20A, 20B, 20C) being **characterized in that** the first electrode and the second electrode (220, 230) respectively comprise a first and a second interface layer (225, 235), each comprising poly(3,4-ethylenedioxythiophene), the first and second interface layer (225, 235) being interposed between the active layer (240) and respectively the first and second metal layer (221, 231) separating said active layer (240) of said first and second metal layer (221, 231) so that the active layer (240) is not in contact with the first and second metal layer (221, 231).

2. The electromechanical device (20) according to claim 1, wherein each of the first and second interface layer further comprises poly(sodium styrene sulfonate), tetramethylacrylate and/or polyaniline.

3. The electromechanical device (20) according to any one of the preceding claims, wherein the at least one ferroelectric polymer is selected from a poly(vinylidene fluoride) and a poly(vinylidene-co-trifluoroethylene fluoride) copolymer.

4. The electromechanical device (20) according to claim 1 or 2, wherein the first and second metal layer (221, 231) comprises at least one of metal particles and metal wires, said metal particles and/or metal wires being made preferably of silver particles and silver wires.

5. The electromechanical device (20) according to any one of claims 1 to 4, wherein at least one of the first and the second electrode (220, 230) further comprises a carbon layer (228, 238) covering the corresponding metal layer (221, 231).

6. The electromechanical device (20) according to any one of claims 1 to 5, wherein the active layer (240) includes a plurality of portions (241) each extending along a plane of the electromechanical device parallel to each other, the portions (241) succeeding one another along a direction perpendicular to the plane of the electromechanical device, two successive portions (241) being at least partially separated from each other by an intermediate electrode layer (226, 236) comprising a poly(3,4-ethylenedioxythiophene) belonging to one of the first and the second electrode (220, 230) such that for two successive intermediate electrode layers (226, 236), one intermediate electrode layer (226) is comprised in the first electrode (220) and the other intermediate electrode layer 236) is comprised in the second electrode (230).

7. The electromechanical device (20) according to claim 6, wherein the active layer (240) includes at least one first opening (242) and at least one second opening (243) for respectively the first electrode (220) and the second electrode (230), the first opening (242) extending perpendicularly to the plane of the electromagnetic device (20) by intercepting the intermediate electrode layers (226) of only the first electrode (220) and the second opening (243) extending perpendicularly to the plane of the electromagnetic device (20) by intercepting the intermediate electrode layers (236) of only the first electrode (230),
the first electrode (220) further comprising a first interconnection (227) extending into the first opening in contact with the intermediate electrode layers (226) of the first electrode (220) and the second electrode (230) further comprising a second interconnection (237) extending into the first opening in contact with the intermediate electrode layer (236) of the second electrode (230).

8. The electromechanical device (20) according to claim 7, wherein the first interconnection (227) and the second interconnection (237) each comprise at least one poly(3,4-ethylenedioxythiophene).

9. The electromechanical device (20) according to any one of the preceding claims, further comprising a first metal track (252) connected to the first electrode (220) and a second metal track (253) connected to the second electrode 230).

10. The electromechanical device (20) according to claim 9 as combined with claim 7 or 8, wherein the first metal layer (221) and the first interface layer (225) extend from the first metal track 252) in contact with the active layer (240) and along a perpendicular direction so as to connect the first interconnection (227) and therefore the intermediate electrode layers (226) of the first electrode (220),
the second metal layer (231) and the second interface layer 235) extend from the second metal track (253) in contact with the active layer (240) and along a perpendicular direction so as to connect the second interconnection (237) and therefore the intermediate electrode layers (236) of the second electrode (230).

11. The electromechanical device according to claim 9 alone or in combination with claim 10, wherein the first metal track (252) comprises a first main track (252E), at least a first connection track (252B) prolonged towards the first main track (252E) to connect the first main track (252E) to the first electrode (220), and at least a first secondary track (252C, 252D) connecting the first electrode (220) to the first main track parallel (252E) to the first connection track (252B),
and wherein the second metal track (253) comprises a second main track (253E), at least one second connection track (253B) prolonged towards the second main track (253E) to connect the second main track (252E) to the second electrode (220), and at least a second secondary track (253C, 253D) connecting the second electrode (230) to the second main track parallel to the second connection track (253B).

12. A method for manufacturing an electromechanical device comprising the following steps:
- formation of a first and second electrodes (220, 230), the first electrode (220) comprising at least a first metal layer (221) and a second electrode (230) comprising at least a second metal layer (231),
- formation of an active layer (240) comprising a ferroelectric polymer, said active layer (240) being disposed between the first and the second electrode (220, 230) in electrical contact with said first and second electrodes (220, 230),
the manufacturing method being **characterised in that** during the formation of the first electrode it is furthermore formed a first and a second interface layer (225, 235) each comprising a poly(3,4-ethylenedioxythiophene) such that the first and second interface layer (225, 235) is interposed between the active layer (240) and respectively the first and second metal layer (221, 231) separating the active layer (240) from said first and second metal layer (221, 231) so that the active layer (240) is not in contact with the first and second metal layers (221, 231).

13. The manufacturing method according to claim 12, wherein the step of forming the first and the second electrodes (220, 230) comprises the following sub-steps:
- deposition of at least one prepolymer of poly(3,4-ethylenedioxythiophene),
- first thermal annealing in order to define the interface layer,
- deposition of a metal ink,
- second thermal annealing in order to define the metal layer,
- global thermal annealing, whether or not the same as one of the first and second thermal annealing, to each form the interface layer and the metal layer.

14. The manufacturing method according to claim 12 or 13, wherein the step of forming the first and the second electrodes (220, 230) further comprises the sub-steps of:
- deposition of carbon ink,
- third thermal annealing in order to define the carbon layer, said third annealing may or may not be the same as an overall thermal annealing.
